# EUROPEAN PATENT SPECIFICATION

(11) **EP 4 148 778 B1**
(45) Date of publication and mention of the grant of the patent: **01.01.2025**
(21) Application number: 21822052.3
(22) Date of filing: 16.03.2021
(51) Int. Cl.: H01L 23/492, H01L 23/00, H01L 23/24, H01L 23/373, H01L 23/367, H01L 23/053, H01L 23/31, H01L 23/538, H01L 25/07

(54) **POWER SEMICONDUCTOR MODULE**
LEISTUNGSHALBLEITERMODUL
MODULE SEMI-CONDUCTEUR DE PUISSANCE

(30) Priority: 12.06.2020 CN 202010535948
(43) Date of publication of application: 15.03.2023
(73) Proprietor: Wuxi Leapers Semiconductor Co., Ltd., Wuxi, Jiangsu 214072 (CN)
(72) Inventor: LIANG, Xiaoguang, Wuxi, Jiangsu 214072 (CN)
(74) Representative: Bayramoglu et al.
(86) International application number: PCT/CN2021/080899
(87) International publication number: WO 2021/248954

(56) References cited:
- CN-A- 105 706 236
- CN-A- 105 765 715
- CN-A- 112 289 763
- CN-U- 212 907 719
- JP-A- 2016 092 346
- US-A1- 2004 099 944
- US-A1- 2011 241 198
- US-A1- 2016 293 563
- US-A1- 2016 300 770
- US-A1- 2018 166 397

## Description

### TECHNICAL FIELD

The present disclosure relates to the technical field of power semiconductor module packaging and, in particular, to a power semiconductor module.

### BACKGROUND

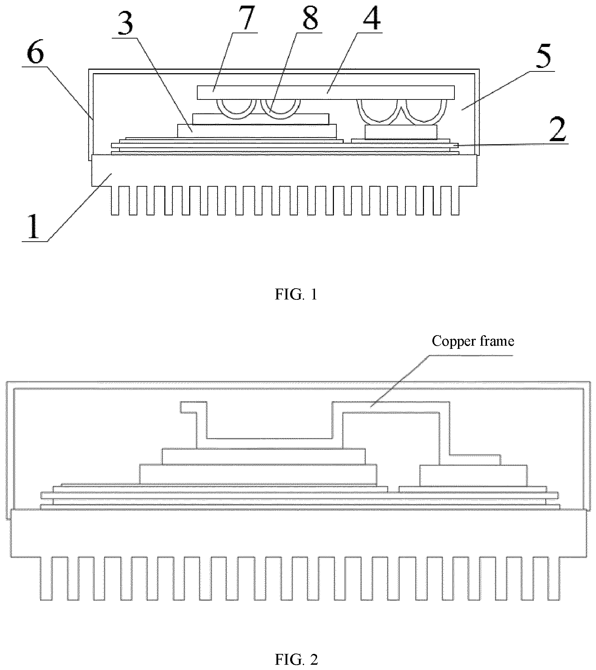

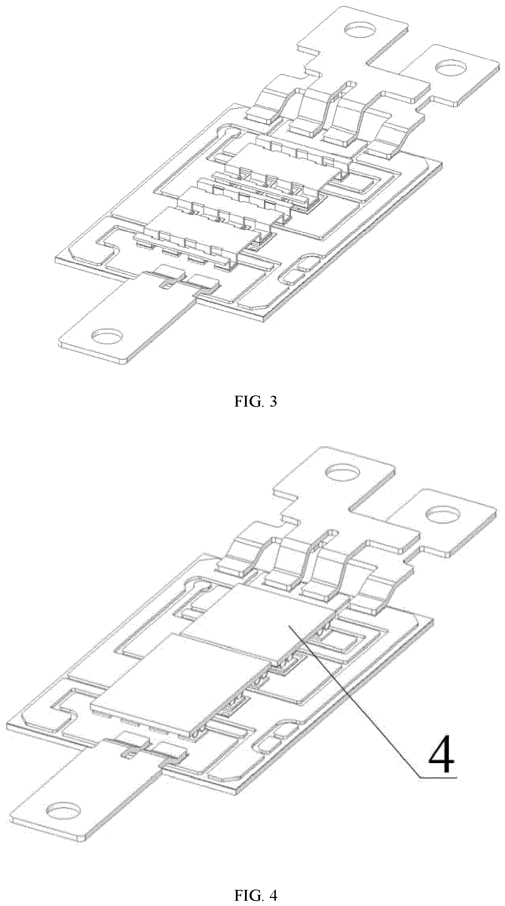

Power semiconductor devices (such as an insulated gate bipolar transistor (IGBT), a metal-oxide-semiconductor field-effect transistor (MOSFET), silicon carbide (SiC), gallium nitride (GaN), and the like) are widely applied to power supplies and power electronic converters. Therefore, module packaging is generally used in a high-power scenario. A power module mainly includes a metal bottom plate, a welding layer, double-sided direct bonding copper (DBC) ceramic substrate, active metal bonding (AMB) ceramic substrate, an insulating heat dissipation resin film or other insulating heat dissipation materials, a copper frame, an outer housing, and silica gel, as shown in FIG. 2 and FIG. 3. Copper has strong conductivity, which can reduce turn-on resistance and parasitic inductance. In addition, the contact area between the copper frame and a chip is large, and the thermal expansion coefficient of the copper is 16.9×10⁻⁶/K, which is much less than the thermal expansion coefficient of aluminum (namely, 23×10⁻⁶ /K) and closer to a thermal expansion coefficient of the chip (namely, 2×10⁻⁶/K to 4×10⁻⁶/K), thereby achieving a longer power cycle life. The bonding with the copper frame also has a series of disadvantages. First, the copper frame is generally made through stamping by using a special die, resulting in a high cost. Second, a relatively thick copper frame needs to be used to reduce the turn-on resistance. However, relatively large mechanical stress is generated on the chip when the temperature on the contact surface between the relatively thick copper frame and the chip changes, which may break or damage the chip in serious cases. Third, when a plurality of chips is connected to the DBC ceramic substrate or other insulating heat dissipation materials, the position of each chip may have a deviation. However, the position of each contact surface of the copper frame cannot be adjusted after the copper frame is processed, which may cause a position deviation during processing, resulting in defective products. To reduce defective products, accurate chip and frame positioning processes are required.

The US patent publication no. US2016300770A1 discloses a power module, specifically an interconnect structure and a package structure of a power module. The power module includes: a base portion having one surface on which an electrode portion is formed; a conductor portion disposed to face the one surface of the base portion on which the electrode portion is formed, for making electrical connection with the outside; and an interconnect portion connected to the electrode portion formed on the one surface of the base portion and to the surface of the conductor portion facing the one surface of the base portion for electrically connecting the electrode portion to the conductor portion.

The US patent publication no. US2016293563A1 discloses an electrode terminal for connecting a main electrode on the front face side of a semiconductor element for electrical power with an external circuit, a semiconductor device for electrical power using the same, and a manufacturing method of that device. The electrode terminal includes: a first drawn-out part to be bonded to a main electrode; and a second drawn-out part that is formed of a plate member in a continuous fashion from one end portion to be positioned opposite to the main electrode with a gap therebetween until another end portion to be connected to an external circuit, so that a portion in the first drawn-out part that is adj acent to a portion therein to be bonded to the main electrode, is bonded to an opposing surface to the main electrode in said one end portion; wherein the first drawn-out part is formed so that the portion to be bonded to the main electrode is away from the opposing surface; and wherein an opening portion corresponding to the main electrode is formed in the second drawn-out part.

The US patent application publication US2018166397 A1 discloses a power semiconductor module with a metal connecting plate connecting an internal circuit portion and a semiconductor element. The metal connecting plate does not touch the outer housing of the power semiconductor module.

Although the above-mentioned prior art documents provide improvements in the connection of components in power semiconductor modules, there is still a need for enhancement of thermal management and for reducing the risk of cracking or failure due to thermal cycling or mechanical stress.

### SUMMARY

The present disclosure provides a power semiconductor module to resolve the prior-art problem of mechanical stress generated on a chip in the case of a temperature change when a relatively thick copper frame is applied to the packaging of the power semiconductor module.

To resolve the above technical problem, the present disclosure provides a power semiconductor as defined in claim 1.

The dependent claims define preferred embodiments of the invention.

The present disclosure has the following beneficial effects: 1. Compared with the prior art, in the power semiconductor module in the present disclosure, the copper strap in contact with the chip generates small mechanical stress on the chip when a temperature change occurs on the copper strap so it does not break or damage the chip. Most of the current of the circuit passes through the relatively thick copper plate, which greatly reduces turn-on resistance and parasitic inductance. 2. The position deviation of the chip can be compensated for by adjusting the position of the copper strap, thus lowering the requirement for a positioning process. This simplifies the processing technology and improves the yield of products.

### BRIEF DESCRIPTION OF THE DRAWINGS

FIG. 1 is a schematic diagram of an overall structure of a power semiconductor module according to an embodiment of the present invention;
FIG. 2 is a schematic diagram of an overall structure of a power semiconductor module with a copper frame;
FIG. 3 is a schematic diagram of a power semiconductor module with a copper frame;
FIG. 4 is a first schematic diagram of a partial structure of a power semiconductor module according to an embodiment of the present invention;
FIG. 5 is a first schematic structural diagram of a binding plate according to an embodiment of the present disclosure;
FIG. 6 is a second schematic structural diagram of a binding plate according to an embodiment of the present disclosure;
FIG. 7 is a second schematic diagram of a partial structure of a power semiconductor module not according to an embodiment of the present invention; and
FIG. 8 is a schematic structural diagram of a power semiconductor module not according to Embodiment 4 of the present invention.

Reference numerals: 1: metal bottom plate; 2: insulating heat dissipation material layer; 3: chip; 4: binding plate; 5: silica gel; 6: outer housing; 7: copper plate; 8: copper strap.

### DETAILED DESCRIPTION OF THE EMBODIMENTS

To make the objective, technical solutions, and advantages of the present disclosure clear, the present disclosure will be further described in detail below by referring to the accompanying drawings and specific embodiments.

### Embodiment 1

As shown in FIG. 1, FIG. 4, and FIG. 5, the present disclosure provides a power semiconductor module, including metal bottom plate 1, insulating heat dissipation material layer 2, chip 3, binding plate 4, silica gel 5, and outer housing 6. The binding plate 4 includes copper plate 7 and a plurality of copper straps 8. The copper plate 7 is connected to the plurality of copper straps 8 through welding, and the binding plate 4 is configured to connect circuits of various components. The metal bottom plate 1 is connected to the insulating heat dissipation material layer 2 through tin soldering. The chip 3 is connected to the insulating heat dissipation material layer 2 through tin soldering. The chip 3 is also connected to a part of the plurality of copper straps 8, and the other part of the plurality of copper straps 8 is connected to the insulating heat dissipation material layer 2.

Further, preferably, the outer housing 6 is connected to the metal bottom plate 1 by using a dispensing process.

Further, preferably, the silica gel 5 fills the outer housing 6 to prevent corrosion and moisture, protect an internal circuit, and isolate internal components with a high voltage.

Further, preferably, the copper plate 7 is connected to the plurality of copper straps 8 through laser welding and ultrasonic welding.

The thickness of the copper plate 7 ranges from 1 mm to 2 mm, and the thickness of the copper strap 8 ranges from 0.3 mm to 0.8 mm.

### Embodiment 2

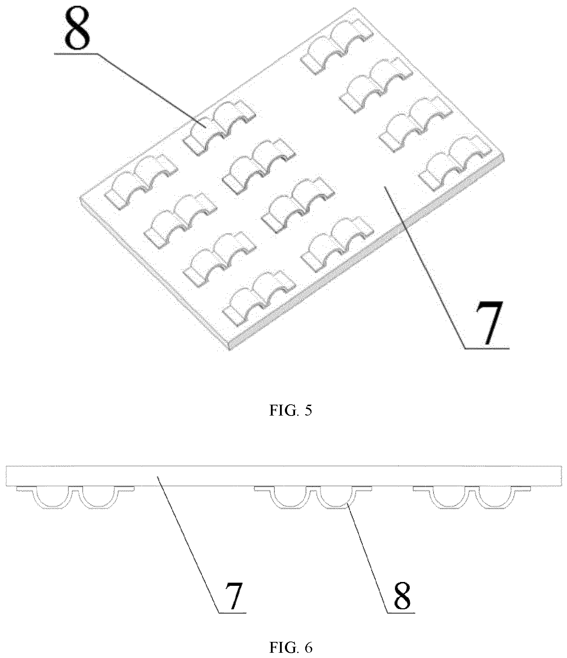

As shown in FIG. 1 and FIG. 6, the present disclosure provides a power semiconductor module, including metal bottom plate 1, insulating heat dissipation material layer 2, chip 3, binding plate 4, silica gel 5, and outer housing 6, where the binding plate 4 includes copper plate 7 and a plurality of copper straps 8. The copper plate 7 is connected to the plurality of copper straps 8 through welding. The binding plate 4 is configured to connect circuits of various components. The metal bottom plate 1 is connected to the insulating heat dissipation material layer 2 through tin soldering. The chip 3 is connected to the insulating heat dissipation material layer 2 through tin soldering and, the chip 3 is connected to a part of the plurality of copper straps 8, and the other part of the plurality of copper straps 8 is connected to the insulating heat dissipation material layer 2.

Further, preferably, the outer housing 6 is connected to the metal bottom plate 1 by using a dispensing process.

Further, preferably, the silica gel 5 fills the outer housing 6 to prevent corrosion and moisture, protect an internal circuit, and isolate internal components with a high voltage.

Further, preferably, the copper plate 7 is connected to the plurality of copper straps 8 through laser welding and ultrasonic welding.

The thickness of the copper plate 7 ranges from 1 mm to 2 mm, and the thickness of the copper strap 8 ranges from 0.5 mm to 1 mm.

A contact surface between the copper strap 8 and the chip 3 is ground to eliminate a deviation, thereby increasing the contact area between the copper strap 8 and the chip 3. In addition, the thickness of the copper strap 8 on the contact surface between the copper strap 8 and the chip 3 is further reduced to reduce mechanical stress when the copper strap 8 is combined with the chip 3, thereby further improving reliability.

### Embodiment 3

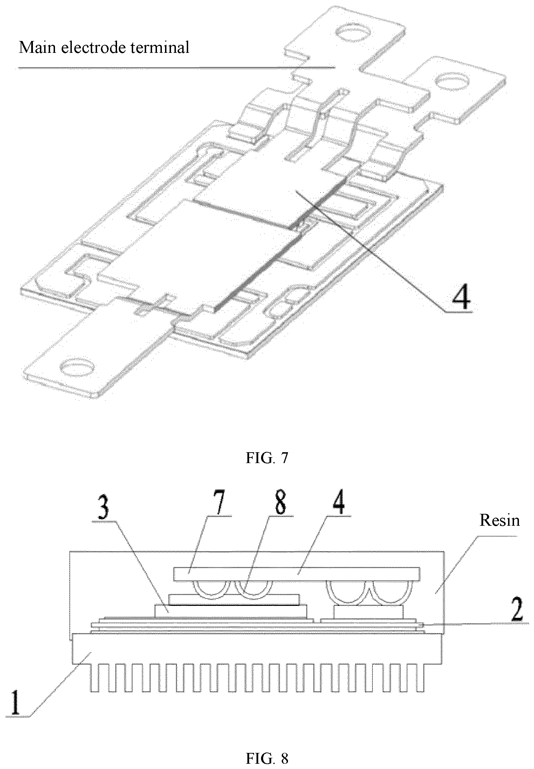

As shown in FIG. 1 and FIG. 7, the present disclosure provides a power semiconductor module, including metal bottom plate 1, insulating heat dissipation material layer 2, chip 3, binding plate 4, silica gel 5, and outer housing 6, where the binding plate 4 includes copper plate 7 and a plurality of copper straps 8. The copper plate 7 is connected to the plurality of copper straps 8 through welding, and the binding plate 4 is configured to connect circuits of various components. The metal bottom plate 1 is connected to the insulating heat dissipation material layer 2 through tin soldering, the chip 3 is connected to the insulating heat dissipation material layer 2 through tin soldering, the chip 3 is connected to a part of the plurality of copper straps 8, and the other part of the plurality of copper straps 8 is connected to the insulating heat dissipation material layer 2.

Further, preferably, the outer housing 6 is connected to the metal bottom plate 1 by using a dispensing process.

Further, preferably, the silica gel 5 fills the outer housing 6 to prevent corrosion and moisture, protect an internal circuit, and isolate internal components with a high voltage.

Further, preferably, the copper plate 7 is connected to the plurality of copper straps 8 through laser welding and ultrasonic welding.

The thickness of the copper plate 7 ranges from 1 mm to 2 mm, and the thickness of the copper strap 8 ranges from 0.3 mm to 0.8 mm.

In accordance with an embodiment not according to the invention, the copper plate 7 and a main electrode terminal form an integrated structure.

In FIG. 4, the copper plate 7 is separated from an electrode terminal for connecting an external circuit, which generates additional resistance and parasitic inductance. In this embodiment, the copper plate 7 and the main electrode terminal form the integrated structure, thereby further reducing the resistance and parasitic inductance.

### Embodiment 4

As shown in FIG. 8, the present disclosure provides, in an embodiment not forming part of the invention as claimed, a power semiconductor module, including metal bottom plate 1, insulating heat dissipation material layer 2, chip 3, and binding plate 4. The binding plate 4 includes copper plate 7 and a plurality of copper straps 8, and the copper plate 7 is connected to the plurality of copper straps 8 through welding. The binding plate 4 is configured to connect circuits of various components. The metal bottom plate 1 is connected to the insulating heat dissipation material layer 2 through tin soldering, the chip 3 is connected to the insulating heat dissipation material layer 2 through tin soldering, the chip 3 is connected to a part of the plurality of copper straps 8, and the other part of the plurality of copper straps 8 is connected to the insulating heat dissipation material layer 2.

Further, preferably, the copper plate 7 is connected to the plurality of copper straps 8 through laser welding and ultrasonic welding.

The thickness of the copper plate 7 ranges from 1 mm to 2 mm, and the thickness of the copper strap 8 ranges from 0.3 mm to 0.8 mm.

The semiconductor module is plastically packaged using a resin material. Based on the shape and parameter design needs, a special die is used to fill the resin into the semiconductor module. The chip 3, the insulating heat dissipation material layer 2, and the binding plate 4 of the semiconductor module are packaged and fixed, for example, 5 and 6 in FIG. 1 are replaced by an integrated resin material. In accordance with an embodiment outside the scope of the invention as claimed, this integrated plastic packaging method does not require silica gel or an outer housing, thereby simplifying the production process and achieving higher production efficiency and higher product reliability.

In conclusion, in the power semiconductor module in the present disclosure, the copper strap in contact with the chip generates small mechanical stress on the chip when a temperature change occurs on the copper strap so it does not break or damage the chip. Most of the current of the circuit passes through the relatively thick copper plate, which greatly reduces turn-on resistance and parasitic inductance. In addition, the position deviation of the chip can be compensated for by adjusting the position of the copper strap, thus lowering the requirement for a positioning process. This simplifies the processing technology and improves the yield of the product.

The above description describes merely preferred embodiments of the present disclosure and is not intended to limit the present disclosure, and various changes and modifications of the present disclosure may be made by those skilled in the art.

The invention includes any modification, equivalent substitution, and improvement made within the scope of the appended claims.

## Claims

1. A power semiconductor module, comprising a metal bottom plate (1), an insulating heat dissipation material layer (2), a chip (3), a binding plate (4), silica gel (5), and an outer housing (6), wherein
the binding plate (4) comprises a copper plate (7) and a copper strap (8), the copper plate (7) is connected to the copper strap (8) through welding,
the binding plate (4) is configured to connect circuits of various components,
the metal bottom plate (1) is connected to the insulating heat dissipation material layer (2) through tin soldering,
the chip (3) is connected to the insulating heat dissipation material layer (2) through tin soldering,
the copper plate (7) is connected to the chip (3) via the copper strap (8), and the copper plate (7) is connected to the insulating heat dissipation material layer (2) via the copper strap (8),
**characterized in that** the copper plate (7) does not touch with the outer housing (6).

2. The power semiconductor module according to claim 1, wherein the outer housing (6) is connected to the metal bottom plate (1) by using a dispensing process.

3. The power semiconductor module according to claim 1, wherein the silica gel (5) fills the outer housing (6) to prevent corrosion and moisture, protect an internal circuit, and isolate internal components with a high voltage.

4. The power semiconductor module according to claim 1, wherein the plurality of copper straps (8) are connected to the copper plate (7) through laser welding and ultrasonic welding.

## Patentansprüche

1. Leistungshalbleitermodul, bestehend aus einer Metallbodenplatte (1), einer isolierenden Wärmeableitungsmaterialschicht (2), einem Chip (3), einer Bindeplatte (4), Kieselgel (5) und einem Außengehäuse (6), wobei
die Bindeplatte (4) eine Kupferplatte (7) und ein Kupferband (8) umfasst, die Kupferplatte (7) durch Schweißen mit dem Kupferband (8) verbunden ist,
die Bindeplatte (4) ausgelegt ist, um Schaltkreise verschiedener Komponenten zu verbinden,
die Metallbodenplatte (1) durch Zinnlöten mit der isolierenden Wärmeableitungsmaterialschicht (2) verbunden ist,
der Chip (3) durch Zinnlöten mit der isolierenden Wärmeableitungsmaterialschicht (2) verbunden ist,
die Kupferplatte (7) über das Kupferband (8) mit dem Chip (3) verbunden ist und die Kupferplatte (7) über das Kupferband (8) mit der isolierenden Wärmeableitungsmaterialschicht (2) verbunden ist,
**dadurch gekennzeichnet, dass** die Kupferplatte (7) das Außengehäuse (6) nicht berührt.

2. Leistungshalbleitermodul nach Anspruch 1, wobei das Außengehäuse (6) durch Nutzung eines Dosierprozesses mit der Metallbodenplatte (1) verbunden ist.

3. Leistungshalbleitermodul nach Anspruch 1, wobei das Kieselgel (5) das Außengehäuse (6) füllt, um Korrosion und Feuchtigkeit zu vermeiden, eine internen Schaltkreis zu schützen und interne Komponenten mit einer hohen Spannung zu isolieren.

4. Leistungshalbleitermodul nach Anspruch 1, wobei die Vielzahl von Kupferbändern (8) durch Laserschweißen und Ultraschallschweißen mit der Kupferplatte (7) verbunden ist.

## Revendications

1. Module semi-conducteur de puissance, comprenant une plaque inférieure métallique (1), une couche isolante de matériau de dissipation thermique (2), une puce (3), une plaque de liaison (4), un gel de silice (5) et un boîtier externe (6), dans lequel
la plaque de liaison (4) comprend une plaque de cuivre (7) et une bande de cuivre (8), la plaque de cuivre (7) est reliée à la bande de cuivre (8) par soudage,
la plaque de liaison (4) est configurée pour relier des circuits de divers composants,
la plaque inférieure métallique (1) est reliée à la couche isolante de matériau de dissipation thermique (2) par brasage à l'étain,
la puce (3) est reliée à la couche isolante de matériau de dissipation thermique (2) par brasage à l'étain,
la plaque de cuivre (7) est reliée à la puce (3) à travers la bande de cuivre (8), et la plaque de cuivre (7) est reliée à la couche isolante de matériau de dissipation thermique (2) à travers la bande de cuivre (8),
**caractérisé en ce que** la plaque de cuivre (7) ne touche pas le boîtier externe (6).

2. Module semi-conducteur de puissance selon la revendication 1, dans lequel le boîtier externe (6) est relié à la plaque inférieure métallique (1) en utilisant un procédé de distribution.

3. Module semi-conducteur de puissance selon la revendication 1, dans lequel le gel de silice (5) remplit le boîtier externe (6) pour empêcher la corrosion et l'humidité, protéger un circuit interne et isoler des composants internes à haute tension.

4. Module semi-conducteur de puissance selon la revendication 1, dans lequel la pluralité de bandes de cuivre (8) sont reliées à la plaque de cuivre (7) par soudage au laser et soudage par ultrasons.
